# EUROPEAN PATENT APPLICATION

(11) **EP 2 169 415 A1**
(43) Date of publication of application: **31.03.2010**
(21) Application number: 08017181.2
(22) Date of filing: 30.09.2008
(51) Int. Cl.: G01R 33/54

(54) **Method for automatic quality control of in-vivo human brain MRI images**

(71) Applicant: Siemens Schweiz AG, 8047 Zürich (CH)
(72) Inventor: Mortamet, Bènédicte, 1003 Lausanne (CH); Krueger, Gunnar, 1007 Lausanne (CH)
(74) Representative: Fischer, Michael

(57) **Abstract**

A method for providing quality control assessments in single time-point in vivo magnetic resonance imaging data related to said imaging of objects is proposed, whereby:
- at least one in-vivo image of said object is acquired by means of an imaging apparatus,
- a background image is defined for corresponding to an imaged air of said in-vivo image,
- an object image is defined for corresponding to said in-vivo image from which said background image has been removed,
- said background image and said object image are obtained by means of an atlas based registration,
- an histogram is provided which reflects an intensity distribution of the background image,
- a noise mathematical model is fitted to at least a part of the intensity distribution of the histogram,
- characteristics on quality of background is derived from said noise mathematical model,
- a further histogram is provided that reflects an intensity distribution of the object image,
- a signal mathematical model is filled to intensity distribution of the further histogram,
- characteristics on quality of object is derived from said signal mathematical model,
- a signal to noise ratio arid a contrast to noise ratio of in-vivo imaging data are automatically derived from said characteristics on quality of object and from said characteristics on quality of background.

## Description

The invention relates to a method for automatic quality control of data in in-vivo images according to claim 1.

The proposed invention intends to achieve quality control assessments of in *vivo* single time-point imaging data in an automated manner and especially MR based data (Magnetic Resonance based imaging data). Quality control of MR-Images is of great importance as it strongly influences the significance and reliability of diagnostic conclusions drawn from their analysis. Standard procedures include measurements of Signal-to-Noise Ratio (abbreviated with SNR) and Contrast-to-Noise Ratio (abbreviated with CNR) that require a high level of user interaction.

To determine SNR from a single image, the most commonly used technique is based on imaging signal statistics focused on delineation of two separate regions of interest (abbreviated with ROIs): one in the tissue of interest (i.e. brain tissue) to determine a signal intensity, the other in a background (i.e. air) to measure a noise intensity [1,2]. Finding a suitable ROI of said background for in *vivo* measurements requires user interaction which appears adequate to perform unitary tests but is not clinically acceptable to be routinely used as this procedure is tedious and error prone. For the time, no automated technique to define background ROIs from a single acquisition of image has been used to derive quality control measurement or evaluation.

One goal underlying to be achieved is to be seen in providing effective quality control assessments in single time-point in vivo imaging data in an automated manner, especially for MR based imaging data.

A method according to the invention is proposed for providing an automatic quality control of a single human part of human body (e.g. a brain) by means of a MR image and is achieved in a process comprising following steps.

Firstly, a step of background delineation is performed on an incoming imaging data from an imaging apparatus by means of an affine transformation like a 12-parameters affine registration algorithm between a reference MR-image (which has been previously segmented into whole head and brain tissue and stored) and an incoming live in-vivo-image of the head.

This resulting transformation encodes a spatial *voxel-by-voxel* correspondence between both previous images that can be further applied to a reference labeled image (where a first label corresponds to a background related ROI and a second label corresponds to a brain tissue related ROI) to simultaneously provide a mask for each of the two ROIs: one for background (i.e. original image excluding all imaged tissue, leaving out only a so called "imaged air") and one for brain tissue.

Secondly, a model is fitted to an intensity distribution of the background ROI that can be provided under a form of histogram. This model consisting in a chi based function (see reference [3]) is fitted to said histogram using maximum likelihood estimation (see reference [4]). An absolute difference that can be evaluated in real-time and automatically between some values of histogram and the fitted model (that can be interpreted as a so-called residual) is an effective indicator of quality control assessment for an dynamical in-vivo-imaging.

Thirdly, over all *voxels* of the mask related to brain tissue, a three tissue classes histogram can be modelled by means of three Gaussian or similar distributions (gray/white matter and cerebrospinal fluid). Their mean and standard deviation are well suited to *evaluate* the quality of brain tissue signal intensity. Finally, a SNR estimator is calculated as a mean intensity of the signal divided by the standard deviation of the background noise derived from above-outlined model. The CNR is evaluated as the difference between gray and white matter mean intensities divided by the standard deviation of the the background noise derived from the above-outlined model.

Optionnaly, the method according to the invention can be tuned to be more sensitive to particular artefact pattern (e.g. eye *movement* creates artefacts only along a phase-encoding direction). Introducing models with prior-knowledge about spatial pattern of different artefact sources may allow a more detailed analysis of the background.

Hence, based on a single image capture (over complex, magnitude image or k-space based data), the proposed invention enables an automatically classification of imaged data quality and allows a further advantageous detection of subject-induced (physiological, motion, etc.), imaging apparatus or other scanner related artefacts prospectively or retrospectively.

A main *advantage* of the method proposed in the invention is that it allows to automatically derive quality measurements from a MR image (in previous example from a human brain). It is a mean to test the eligibility of data to further guarantee accurate and reproducible post-processing measurements such as for a brain tissue classification.
Further *advantages* of this invention rely in that:
a) a quality assurance analysis can be carried out on the background noise only, allowing the detection of ringing/ghosting artefacts (generally caused by bulk head motion), flow artefacts (due to blood or fluid flow within the brain) or system related artefacts (radiofrequences, spikes, etc) as they introduce high-intensity "noise" *voxels,* thus altering noise-related quantities as previously described,
b) a poor slice positioning such as nose or chin wrap can be detected during the first step (i.e. registration) since these head features are spatially encoded in the reference MR-Image.

The present invention proposes hence a method for providing quality control assessments in single time-point in vivo imaging data related to said imaging of objects, in an automated manner according to claim 1.

In resume, the method according to the invention for providing quality control assessments in single time-point in vivo imaging data related to said imaging of objects comprises mainly following steps:
- at least one in-vivo image of said object is acquired by means of an imaging apparatus,
- a background image is defined for corresponding to an imaged air of said in-vivo image,
- an object image is defined for corresponding to said in-vivo image from which said background image has been removed,
- said background image and said object image are obtained by means of an atlas based registration,
- an histogram is provided which reflects an intensity distribution of the background image,
- a noise mathematical model is fitted to at least a part of the intensity distribution of the histogram,
- characteristics on quality of background is derived from said noise mathematical model,
- a further histogram is provided that reflects an intensity distribution of the object image,
- a signal mathematical model is fitted to intensity distribution of the further histogram,
- characteristics on quality of object is derived from said signal mathematical model,
- a signal to noise ratio and a contrast to noise ratio of in-vivo imaging data are automatically derived from said characteristics on quality of object and from said characteristics on quality of background.

Said quality control assessment can be provided over a data processing based on spacially or frequency coordinates. The method according to the invention is hence mathematically adaptable to a large field of physical imaging/computing methods.

Said object can be divided in several compartments that are modelled mathematically in an independent manner, particularly in case of a plurality of tissues. The method according to the invention is hence highly adaptable for complex in-vivo imaging of human body parts.

As example, the object can be a brain on which each of three main tissue types, adapted to gray matter, white matter and cerebrospinal fluid, are mathematically modelled by a gaussian or similar distribution. This segmentation in only three types of tissues is very effective in term of providing automatically very good quality control assessment on an imaging of brain.

More precisely, the signal to noise ratio can be simply calculated as a mean intensity of one of the three said tissue types derived from said signal mathematical model divided by a standard deviation of said background intensities derived from said noise mathematical model.

A well, the contrast to noise ratio is also simply calculated as a difference between two tissue mean intensities derived from the said signal mathematical model divided by a standard deviation of said background intensities derived from said noise mathematical model.

This calculations are advantageously automatic-able and executable under high rates that are well-suited for a dynamical quality control of in-vivo-imaging.

An simple integral value of an evaluated absolute difference between said mathematical model and said histogram of said background can be used as a very effective predictor or indicator of quality of in-vivo-imaging.

The described methods are further explained by the following example and drawing, whereby:

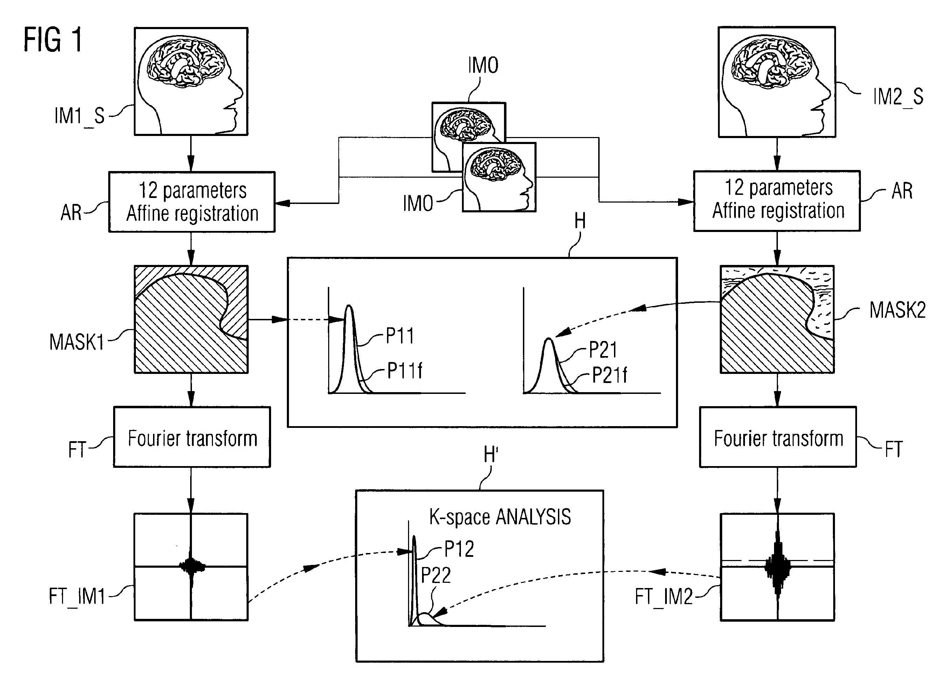

- Drawing 1: shows an evaluation diagram of data quality according to the method of the invention and comprising a first set of high quality imaged data (on the left) and a second set of low quality imaged data.

Drawing 1 presents an evaluation diagram of data quality according to the method of the invention and comprising a first set of high quality imaged data IM1_S (on the left) and a second set of low quality imaged data IM2_S, whereby:
- at least one in-vivo image IM0 of said object is acquired by means of an imaging apparatus (like a MR-apparatus, non represented),
- a background image MASK1, MASK2 is defined for corresponding to an imaged air of said in-vivo image,
- an object image is defined for corresponding to said in-vivo image from which said background image has been removed,
- said background image and said object image are obtained by means of an atlas based registration AR (= e.g. an affine transformation),
- an histogram H is provided which reflects an intensity distribution P11, P21 of the background image,
- a noise mathematical model P11f, P21f is fitted to at least a part of the intensity distribution P11, P21 of the histogram H,
- characteristics on quality of background is derived from said noise mathematical model,
- in the same manner, a further histogram is provided that reflects an intensity distribution of the object image,
- a signal mathematical model is fitted to intensity distribution of the further histogram,
- characteristics on quality of object is derived from said signal mathematical model,
- a signal to noise ratio and a contrast to noise ratio of in-vivo imaging data are automatically derived from said characteristics on quality of object and from said characteristics on quality of background.

The described quality control assessment is provided over a data processing based on spacial coordinates, but as also shown in drawing 1, said assessement can be also provided over a data processing based on frequency coordinates by means of Fourier transform FT applied to background images MASK1, MASK2. A similar histogram H' is provided over a frequency range and reflects an intensity distribution P12, P22 of the frequency based background image FT_IM1, FT_IM2 of each of high/low quality set of imaging data. Principally the method for providing quality control assessment under this configuration is the same as described above for the intensity distribution over spatial coordinates of imaged objects.

### References

[1] Kaufman L, Kramer DM, Crooks LE, Ortendahl DA. Measuring signal-to-noise ratios in MR imaging. Radiology 1989;173(1):265-267.
[2] Henkelman RM. Measurement of signal intensities in the presence of noise in MR images. Med Phys 1985;12(2):232-233.
[3] Constantinides CD, Atalar E, McVeigh ER. Signal-to-noise measurements in magnitude images from NMR phased arrays. MRM 1997;38(5):852-857.
[4] Duda RO, Hart PE. Pattern Classification and Scene Analysis. Institute SR, editor, New York: Wiley; 1973.

## Claims

1. Method for providing quality control assessments in single time-point in vivo imaging data related to said imaging of objects, whereby:
- at least one in-vivo image of said object is acquired by means of an imaging apparatus,
- a background image is defined for corresponding to an imaged air of said in-vivo image,
- an object image is defined for corresponding to said in-vivo image from which said background image has been removed,
- said background image and said object image are obtained by means of an atlas based registration,
- an histogram (H) is provided which reflects an intensity distribution of the background image,
- a noise mathematical model is fitted to at least a part of the intensity distribution of the histogram (H),
- characteristics on quality of background is derived from said noise mathematical model,
- a further histogram (H) is provided that reflects an intensity distribution of the object image,
- a signal mathematical model is fitted to intensity distribution of the further histogram (H),
- characteristics on quality of object is derived from said signal mathematical model,
- a signal to noise ratio and a contrast to noise ratio of in-vivo imaging data are automatically derived from said characteristics on quality of object and from said characteristics on quality of background.

2. Method according to claim 1, whereby said quality control assessment is provided over a data processing based on spacial or frequency coordinates.

3. Method according to claim 1 or 2, whereby said object is divided in several compartments that are modelled mathematically in an independent manner, particularly in case of a plurality of tissues.

4. Method according to claim 3, whereby the object is a brain on which each of three tissue types, adapted to gray matter, white matter and cerebrospinal fluid, are mathematically modelled by a gaussian or similar distribution

5. Method according to claim 4, whereby the signal to noise ratio is calculated as a mean intensity of one of the three said tissue types derived from said signal mathematical model divided by a standard deviation of said background intensities derived from said noise mathematical model.

6. Method according to claim 4, whereby the contrast to noise ratio is calculated as a difference between two tissue mean intensities derived from the said signal mathematical model divided by a standard deviation of said background intensities derived from said noise mathematical model.

7. Method according to one of previous claims, whereby an integral value of an evaluated absolute difference between said mathematical model and said histogram of said background is used as a predictor or an indicator of quality of in-vivo-imaging.
